(19) Europäisches Patentamt
European Patent Office
Office européen des brevets

(11) **EP 4 191 739 A1**

(12) **EUROPEAN PATENT APPLICATION**
published in accordance with Art. 153(4) EPC

(43) Date of publication:
**07.06.2023 Bulletin 2023/23**

(21) Application number: **20952442.0**

(22) Date of filing: **03.09.2020**

(51) International Patent Classification (IPC):
**H01M 10/44** (2006.01)    **H01M 10/48** (2006.01)

(52) Cooperative Patent Classification (CPC):
**H01M 10/44; H01M 10/48;** Y02E 60/10

(86) International application number:
**PCT/JP2020/033476**

(87) International publication number:
**WO 2022/049705 (10.03.2022 Gazette 2022/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Sony Group Corporation
Minato-Ku, Tokyo, 108-0075 (JP)**

(72) Inventors:
- **FURUKAWA, Hikaru
  Tokyo 140-0002 (JP)**
- **SUZUKI, Kuniharu
  Tokyo 140-0002 (JP)**
- **TANAKA, Go
  Tokyo 140-0002 (JP)**
- **MAKITA, Tetsuya
  Tokyo 140-0002 (JP)**

(74) Representative: **D Young & Co LLP
120 Holborn
London EC1N 2DY (GB)**

(54) **CHARGING CONTROL DEVICE, PORTABLE TERMINAL DEVICE, CHARGING CONTROL METHOD, AND PROGRAM**

(57)    In a charging control device, a charging circuit charges a battery until an output voltage value of the battery reaches a full charge voltage value, and a processor calculates an integrated amount of expansion damage that is damage received by the battery due to expansion of the battery, the processor decreases the full charge voltage value when an expansion damage rate that is an increase rate of the integrated amount of the expansion damage in a predetermined period is equal to or greater than a threshold value, while the processor increases the full charge voltage value when the expansion damage rate is less than the threshold value.

FIG.1

EP 4 191 739 A1

## Description

Field

The present disclosure relates to a charging control device, a mobile terminal device, a charging control method, and a program.

Background

A battery mounted on a mobile terminal device may expand due to repeated charging, and it is dangerous if an amount of expansion of the battery exceeds a certain level. Furthermore, it has been known that the larger the full charge voltage value of the battery, the greater the expansion of the battery, while the expansion of the battery stops when the full charge voltage value of the battery is reduced to a predetermined value. In view of the above, in the mobile terminal device, in order to suppress the amount of expansion of the battery to a certain level, control is performed to gradually reduce the full charge voltage value of the battery as the amount of expansion of the battery increases.

Citation List

Patent Literature

Patent Literature 1: JP 2020-068607 A

Summary

Technical Problem

However, when the full charge voltage value of the battery is reduced, the capacity of the battery decreases, and thus the usable life of the mobile terminal device after the battery is fully charged is shortened.
In view of the above, the present disclosure proposes a technology capable of increasing the usable life of a mobile terminal device while suppressing the expansion of a battery.

Solution to Problem

A charging control device according to the present disclosure includes a charging circuit and a processor. The charging circuit charges a battery until an output voltage value of the battery reaches a full charge voltage value. The processor that calculates an integrated amount of expansion damage that is damage received by the battery due to expansion of the battery. The processor decreases the full charge voltage value when an expansion damage rate that is an increase rate of the integrated amount in a predetermined period is equal to or greater than a threshold value, while the processor increases the full charge voltage value when the expansion damage rate is less than the threshold value.

Brief Description of Drawings

FIG. 1 is a diagram illustrating a configuration example of a mobile terminal device according to a first embodiment of the present disclosure.
FIG. 2 is a diagram provided for describing an operation example of a charging control device according to the first embodiment of the present disclosure.
FIG. 3 is a diagram provided for describing an operation example of the charging control device according to the first embodiment of the present disclosure.
FIG. 4 is a flowchart provided for describing a processing procedure of the charging control device according to the first embodiment of the present disclosure.

Description of Embodiments

Hereinafter, embodiments of the present disclosure will be described with reference to the drawings. Note that, in the following embodiments, the same reference numerals may be given to the same parts or the same processing to omit redundant description.

Furthermore, the technology of the present disclosure will be described according to the order of items described below.

[First embodiment]

        <Configuration of mobile terminal device>
        <Operation of charging control device>
        <Processing of charging control device>

[Second embodiment]
[Third embodiment]
[Advantageous effects of disclosed technology]

[First embodiment]

<Configuration of mobile terminal device>

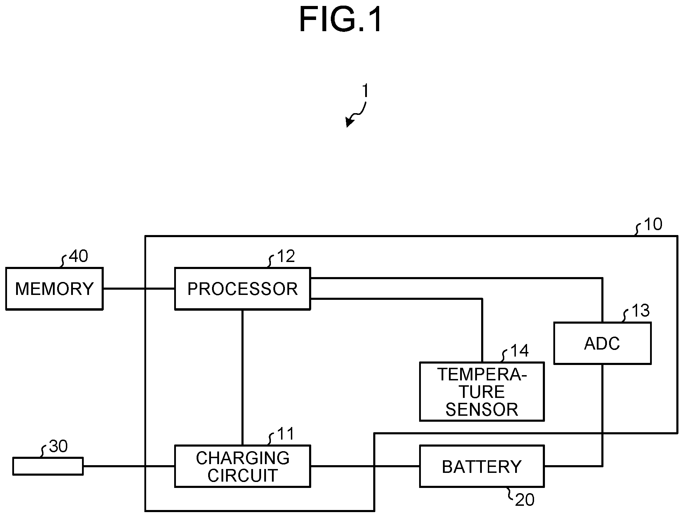

FIG. 1 is a diagram illustrating a configuration example of a mobile terminal device according to a first embodiment of the present disclosure. In FIG. 1, a mobile terminal device 1 includes a charging control device 10, a battery 20, a charging terminal 30, and a memory 40. The charging control device 10 includes a charging circuit 11, a processor 12, an analog-to-digital converter (ADC) 13, and a temperature sensor 14.

As examples of the mobile terminal device 1, a smart device such as a smartphone and a tablet terminal, a notebook type personal computer, and the like are named. As examples of the processor 12, a central processing unit (CPU), a digital signal processor (DSP), a field programmable gate array (FPGA), and the like are named. As examples of the memory 40, a random access memory (RAM) such as a synchronous dynamic random access memory (SDRAM), a read only memory (ROM), a flash memory, and the like are named.

When the battery 20 is charged, a commercial power source is connected to the mobile terminal device 1 via the charging terminal 30, and the battery 20 is charged by the commercial power source. The commercial power source is connected to the charging terminal 30 via an AC adapter (not illustrated), and the AC adapter steps down the commercial power source, which is alternate current of 100 V, for example, to convert into direct-current power source of 5 V.

An output voltage of the battery 20 is input to the ADC 13. The ADC 13 detects an output voltage value of the battery 20 (hereinafter, sometimes referred to as a "battery output voltage value"), converts the detected analog voltage value into a digital voltage value, and outputs the digital battery output voltage value after conversion to the processor 12.

The temperature sensor 14 detects a temperature of the battery 20 (hereinafter, sometimes referred to as a "battery temperature"), and outputs the detected battery temperature to the processor 12.

The processor 12 controls the charging circuit 11 to control charging of the battery 20. Triggered by the commercial power source being connected to the charging terminal 30 via the AC adapter, the processor 12 causes the charging circuit 11 to start charging the battery 20. Furthermore, when the charging circuit 11 charges the battery 20, the processor 12 causes the charging circuit 11 to charge the battery 20 until the battery output voltage value reaches the full charge voltage value.

Furthermore, the processor 12 calculates an integrated amount (hereinafter, sometimes referred to as an "expansion damage integrated amount") [hour] of damage (hereinafter, sometimes referred to as an "expansion damage") received by the battery 20 due to expansion of the battery 20. The processor 12 calculates the expansion damage integrated amount on the basis of a predetermined upper limit value of the full charge voltage value (hereinafter, sometimes referred to as a "full charge upper limit value"), the full charge voltage value at the moment used to control charging at the moment to the charging circuit 11 (hereinafter, sometimes referred to as a "full charge present value"), and the battery temperature. Then, the processor 12 controls the full charge voltage value on the basis of the calculated expansion damage integrated amount.

The charging circuit 11 charges, by using the direct-current power source supplied from the AC adapter, the battery 20 until the battery output voltage value reaches the full charge voltage value under the control of the processor 12.

<Operation of charging control device>

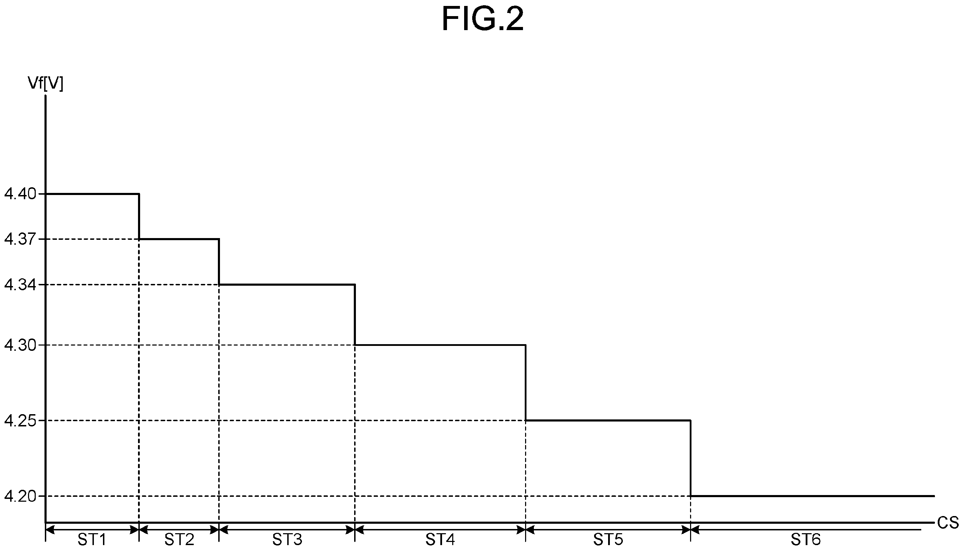

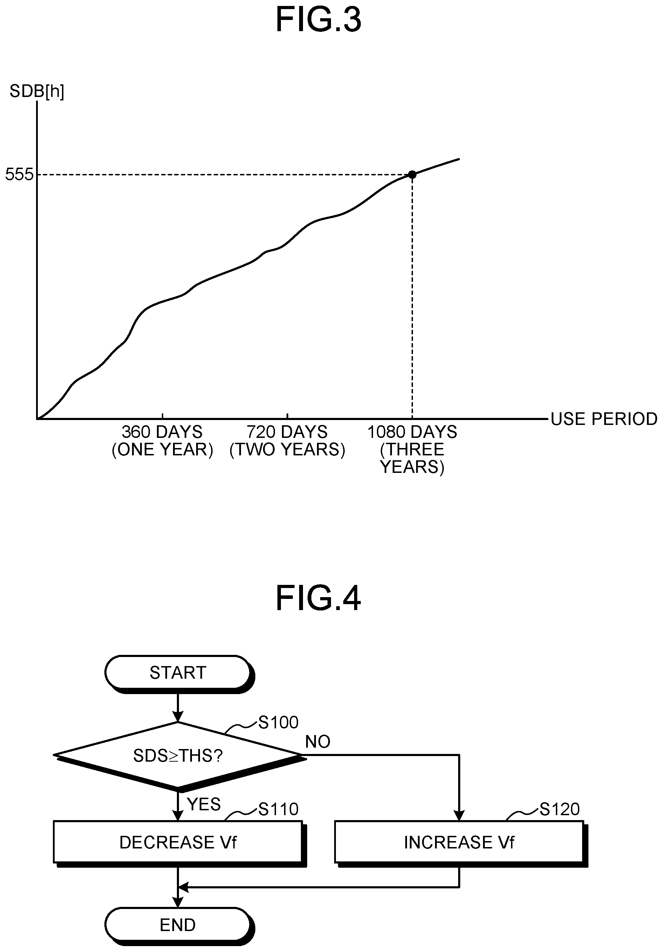

FIGS. 2 and 3 are diagrams provided for describing an operation example of the charging control device according to the first embodiment of the present disclosure.

As illustrated in FIG. 2, the processor 12 decreases a full charge voltage value Vf [V] as the number of charging cycles CS [times] of the battery 20 increases. For example, the processor 12 sets the full charge voltage value Vf to 4.40 [V] when the number of charging cycles CS is 0 to 100 times (stage ST1), sets the full charge voltage value Vf to 4.37 [V] when the number of charging cycles CS is 101 to 200 times (stage ST2), and sets the full charge voltage value Vf to 4.34 [V] when the number of charging cycles CS is 201 to 400 times (stage ST3). Furthermore, for example, the processor 12 sets the full charge voltage value Vf to 4.30 [V] when the number of charging cycles CS is 401 to 800 times (stage ST4), sets the full charge voltage value Vf to 4.25 [V] when the number of charging cycles CS is 801 to 1200 times (stage ST5), and sets the full charge voltage value Vf to 4.20 [V] when the number of charging cycles CS is equal to or greater than 1201 times (stage ST6).

Furthermore, the processor 12 decreases or increases the full charge voltage value on the basis of an increase rate of the expansion damage integrated amount in a predetermined period (hereinafter, sometimes referred to as an "expansion damage rate") with the full charge voltage value set on the basis of the number of charging cycles CS as described above (hereinafter, sometimes referred to as a "charging cycle voltage value") as an upper limit value.

For example, the processor 12 calculates an expansion damage SD [hour] according to Formula (1) 24 times per day every hour constantly at 00 minute of every hour since the mobile terminal device 1 is used for the first time, and calculates the expansion damage integrated amount by sequentially adding up the expansion damage SD calculated every hour.

$$SD = \frac{\exp\left\{(a \cdot Vf + b) + \left(a\frac{1}{Tm} + b\right)\right\}}{\exp(a \cdot Vh + b) \cdot \exp\left(a\frac{1}{Tp} + b\right)} \tag{1}$$

In Formula (1), "a" and "b" are predetermined coefficients determined for each model of the battery 20, and "Vf" is the full charge present value. Furthermore, in Formula (1), "Vh" is the full charge upper limit value, and in a case of the example illustrated in FIG. 2, the full charge upper limit value Vh is 4.40 [V]. Furthermore, in Formula (1), "Tm" is a "residence time", and "Tp" is the battery temperature, and in a case where the expansion damage SD is calculated every hour at 00 minute of every hour, the "Tm" is "1", and the "Tp" is the battery temperature detected by the temperature sensor 14 every hour at 00 minute of every hour.

Furthermore, the processor 12 calculates, every predetermined period, the expansion damage rate by dividing an increase amount of the expansion damage integrated amount in a predetermined period (hereinafter, sometimes referred to as an "expansion damage increase amount") by the length of the predetermined period. For example, in a case where the predetermined period as a calculation reference of the expansion damage rate is "10 days", the processor 12 calculates, every 10 days, an average daily expansion damage rate [hour/day] for the last 10 days by dividing the expansion damage increase amount for 10 days from the previous calculation time point of the expansion damage rate by "10 days".

Furthermore, the processor 12 compares the calculated expansion damage rate with a first threshold value TH1 and a second threshold value TH2 (here, first threshold value TH1 > second threshold value TH2), every time the processor 12 calculates the expansion damage rate. Then, the processor 12 decreases the full charge voltage value Vf when the expansion damage rate is equal to or greater than the first threshold value TH1, while the processor 12 increases the full charge voltage value Vf when the expansion damage rate is less than the second threshold value TH2. Furthermore, the processor 12 maintains the full charge voltage value Vf at the full charge present value when the expansion damage rate is less than the first threshold value TH1 and equal to or greater than the second threshold value TH2.

For example, in FIG. 2, when the full charge present value is Vf = 4.30 [V] and the expansion damage rate is equal to or greater than the first threshold value TH1, the processor 12 decreases the full charge voltage value Vf from 4.30 [V] to 4.25 [V] by just one stage. Furthermore, for example, in FIG. 2, when the full charge present value is Vf = 4.30 [V] and the expansion damage rate is less than the second threshold value TH1, the processor 12 increases the full charge voltage value Vf from 4.30 [V] to 4.34 [V] by just one stage. Furthermore, for example, in FIG. 2, when the full charge present value is Vf = 4.30 [V] and the expansion damage rate is less than the second threshold value TH1, the processor 12 increases the full charge voltage value Vf from 4.30 [V] to 4.34 [V] by just one stage. Furthermore, for example, in FIG. 2, when the full charge present value is Vf = 4.30 [V] and the expansion damage rate is less than the first threshold value TH1 and equal to or greater than the second threshold value TH2, the processor 12 maintains the full charge voltage value Vf at 4.30 [V].

Here, the first threshold value TH1 and the second threshold value TH2 are threshold values set in advance on the basis of the durability of the battery 20 against expansion damage (hereinafter, sometimes referred to as "damage durability") [hour]. For example, in a case where the battery 20 having damage durability of 555 hours is mounted on the mobile terminal device 1, the first threshold value TH1 is calculated according to Formula (2) on the basis of three years (360 x 3 = 1080 days), which is an average use period (hereinafter, sometimes referred to as "average use period") of the mobile terminal device 1 by general users.

$$TH1 = 555 \div 1080 = 0.514 \ [hour/day] \ ... \ (2)$$

Furthermore, in a case where the damage durability of the battery 20 is 555 hours, the second threshold value TH2 is calculated according to, for example, Formula (3).

$$TH2 = (555 - 10) \div 1080 = 0.505 \ [hour/day] \ ... \ (3)$$

Note that, in the above description, the processor 12 changes the full charge voltage value by using the second threshold value TH2 that is a value smaller than the first threshold value TH1. However, the processor 12 may change the full charge voltage value by using the second threshold value TH2 that is the same value as the first threshold value TH1.

As described above, by decreasing and increasing the full charge voltage value according to the threshold values calculated on the basis of the damage durability, the expansion damage rate also decreases and increases in response to the decrease and increase in the full charge voltage value. That is, the expansion damage rate decreases when the full charge voltage value decreases, while the expansion damage rate increases when the full charge voltage value increases. Therefore, by decreasing and increasing the full charge voltage value according to the threshold values calculated on the basis of the damage durability, as illustrated in FIG. 3, the expansion damage integrated amount SDB [hour] reaches 555 hours, which is the damage durability, at the point of time at which 1080 days, which is the average use period, has just elapsed.

<Processing of charging control device>

FIG. 4 is a flowchart provided for describing a processing procedure of the charging control device according to the first embodiment of the present disclosure. The flowchart illustrated in FIG. 4 starts every predetermined period (for example, every 10 days) as the calculation reference of the expansion damage rate. Note that, in FIG. 4, as an example, a case will be described where the first threshold value TH1 and the second threshold value TH2 adopt the same value of a threshold value THS.

In step S100, the processor 12 calculates the expansion damage rate SDS, and compares the calculated expansion damage rate SDS with the threshold value THS.

When the expansion damage rate SDS is equal to or greater than the threshold value THS (step S100: Yes), in step S110, the processor 12 decreases the full charge voltage value Vf.

On the other hand, when the expansion damage rate SDS is less than the threshold value THS (step S100: No), in step S120, the processor 12 increases the full charge voltage value Vf.

With the processing of step S110 or step S120, the flowchart illustrated in FIG. 4 ends.

Note that, in the above description, the processor 12 calculates the expansion damage SD of the battery 20 according to Formula (1). However, a table indicating association among a plurality of full charge present values, a plurality of battery temperatures, and a plurality of expansion damage amounts according to the full charge present values and the battery temperatures (hereinafter, sometimes referred to as an "expansion damage table") may be stored in the memory 40 in advance, and the processor 12 may acquire the expansion damage SD corresponding to the full charge present value and the battery temperature from the expansion damage table by referring to the expansion damage table on the basis of the full charge present value and the battery temperature.

The first embodiment has been described above.

[Second embodiment]

In the first embodiment, the case where the predetermined period as the calculation reference for the expansion damage rate (hereinafter, sometimes referred to as a "damage rate calculation period") is always set to "10 days" irrespective of the magnitude of the full charge voltage value Vf has been described as an example.

On the other hand, in a second embodiment, the damage rate calculation period is changed according to the magnitude of the full charge voltage value Vf. For example, when the full charge present value is 4.40 [V] or 4.37 [V], the processor 12 calculates the expansion damage rate by using the damage rate calculation period set to five days, when the full charge present value is 4.34 [V] or 4.30 [V], the processor 12 calculates the expansion damage rate by using the damage rate calculation period set to 10 days, and when the full charge present value is 4.25 [V] or 4.20 [V], the processor 12 calculates the expansion damage rate by using the damage rate calculation period set to 15 days. In this manner, the processor 12 calculates the expansion damage rate by using shorter damage rate calculation period as the full charge voltage value Vf is larger.

The second embodiment has been described above.

[Third embodiment]

Each processing in the above description in the processor 12 may be implemented by causing the processor 12 to execute a program corresponding to each processing. For example, the program corresponding to each processing in the above description may be stored in the memory 40, and the program may be read from the memory 40 and executed by the processor 12. Furthermore, the program may be stored in a program server connected to the mobile terminal device 1 via an optional network and downloaded from the program server to the mobile terminal device 1 to be executed, or may be stored in a recording medium readable by the mobile terminal device 1 and read out from the recording medium to be executed. Examples of the recording medium readable by the mobile terminal device 1 include portable storage media such as a memory card, a USB memory, an SD card, a flexible disk, a magneto-optical disk, a CD-ROM, a DVD, and a Bluray (registered trademark) disk. Furthermore, the program is described in an optional language or an optional description method, and may be in any form such as a source code or a binary code. Furthermore, the program is not necessarily limited to those constituted in a single manner and may include those constituted in a distributed manner as a plurality of modules or a plurality of libraries and those that achieve the functions thereof in cooperation with a separate program represented by an OS.

The third embodiment has been described above.

[Advantageous effects of disclosed technology]

As described above, the charging control device (charging control device 10 according to the embodiment) of the present disclosure includes the charging circuit (charging circuit 11 according to the embodiment) and the processor (processor 12 according to the embodiment). The charging circuit charges the battery (battery 20 according to the embodiment) until the output voltage value of the battery reaches the full charge voltage value. The processor calculates the integrated amount of the expansion damage that is damage received by the battery due to expansion of the battery. Then, the processor decreases the full charge voltage value when the expansion damage rate that is an increase rate of the integrated amount of the expansion damage in the predetermined period is equal to or greater than the threshold value, while the processor increases the full charge voltage value when the expansion damage rate is less than the threshold value.

In this manner, by not only decreasing the full charge voltage value but also increasing the full charge voltage value according to the expansion damage rate, in the mobile terminal device on which the charging control device of the present disclosure is mounted, it is possible to increase the usable life of the mobile terminal device while suppressing the expansion of the battery.

For example, the threshold value of the expansion damage rate includes the first threshold value and the second threshold value that is a value smaller than the first threshold value, and the processor decreases the full charge voltage value when the expansion damage rate is equal to or greater than the first threshold value, while the processor increases the full charge voltage value when the expansion damage rate is less than the second threshold value.

As a result, it is possible to prevent the full charge voltage value from changing frequently. Accordingly, in the mobile terminal device on which the charging control device of the present disclosure is mounted, it is possible to prevent malfunction of the mobile terminal device that occurs with the frequent change in the full charge voltage value.

Furthermore, the charging control device of the present disclosure further includes the temperature sensor (temperature sensor 14 according to the embodiment) that detects the temperature of the battery. The processor calculates the integrated amount of the expansion damage on the basis of the predetermined upper limit value of the full charge voltage value, the full charge voltage value at the moment, and the temperature detected by the temperature sensor.

As a result, it is possible to accurately calculate the integrated amount of the expansion damage.

Furthermore, the processor decreases the full charge voltage value as the number of charging cycles of the battery increases, while the processor decreases or increases the full charge voltage value on the basis of the expansion damage rate with the full charge voltage value set according to the number of charging cycles as the upper limit value.

As a result, after changing the full charge voltage value on the basis of the number of charging cycles, which is a main cause of deterioration of the battery, the full charge voltage value can be further adjusted on the basis of the expansion damage, which is a dependent cause of deterioration of the battery.

Furthermore, the processor shortens the predetermined period as the calculation reference of the expansion damage rate (the damage rate calculation period according to the embodiment) as the full charge voltage value increases.

As a result, since the expansion damage rate tends to be greater for a while after the use of the battery is started as compared with a stage when the battery reaches the end of its life, it is possible to accurately perform the determination of the threshold value with respect to the expansion damage rate while the battery is in the early stage of use, while it is possible to reduce processing load in the charging control device when the battery reaches the final stage of use.

Note that the advantageous effects described in the present specification are merely examples and are not limited thereto, and there may be other advantageous effects.

Furthermore, the disclosed technology can also adopt the following configurations.

(1) A charging control device including:

a charging circuit that charges a battery until an output voltage value of the battery reaches a full charge voltage value; and

a processor that calculates an integrated amount of expansion damage that is damage received by the battery due to expansion of the battery, the processor decreasing the full charge voltage value when an expansion damage rate that is an increase rate of the integrated amount in a predetermined period is equal to or greater than a threshold value, while the processor increasing the full charge voltage value when the expansion damage rate is less than the threshold value.

(2) The charging control device according to (1), further including

a temperature sensor that detects a temperature of the battery, wherein

the processor calculates the integrated amount on the basis of a predetermined upper limit value of the full charge voltage value, the full charge voltage value at a moment, and the temperature.

(3) The charging control device according to (1) or (2), wherein

the threshold value includes a first threshold value and a second threshold value that is a value smaller than the first threshold value, and

the processor decreases the full charge voltage value when the expansion damage rate is equal to or greater than the first threshold value, while the processor increases the full charge voltage value when the expansion damage rate is less than the second threshold value.

(4) The charging control device according to any one of (1) to (3), wherein
the processor decreases the full charge voltage value as a number of charging cycles of the battery increases, while the processor decreases or increases the full charge voltage value on the basis of the expansion damage rate with the full charge voltage value set according to the number of charging cycles as an upper limit value.

(5) The charging control device according to any one of (1) to (4), wherein
the processor calculates the expansion damage rate by using the predetermined period shorter as the full charge voltage value is larger.

(6) A mobile terminal device including the charging control device according to any one of (1) to (5).

(7) A charging control method for a battery that is charged until an output voltage value reaches a full charge voltage value, the method including:

calculating an integrated amount of expansion damage that is damage received by the battery due to expansion of the battery; and

decreasing the full charge voltage value when an expansion damage rate that is an increase rate of the integrated amount in a predetermined period is equal to or greater than a threshold value, while increasing the full charge voltage value when the expansion damage rate is less than the threshold value.

(8) A program for causing a processor to execute charging control for a battery that is charged until an output voltage value reaches a full charge voltage value,
the program for causing the processor to execute processing of:

calculating an integrated amount of expansion damage that is damage received by the battery due to expansion of the battery; and

decreasing the full charge voltage value when an expansion damage rate that is an increase rate of the integrated amount in a predetermined period is equal to or greater than a threshold value, while increasing the full charge voltage value when the expansion damage rate is less than the threshold value

Reference Signs List

1    MOBILE TERMINAL DEVICE

10    CHARGING CONTROL DEVICE
11    CHARGING CIRCUIT
12    PROCESSOR
13    ADC
14    TEMPERATURE SENSOR
20    BATTERY
30    CHARGING TERMINAL
40    MEMORY

**Claims**

1.  A charging control device including:

    a charging circuit that charges a battery until an output voltage value of the battery reaches a full charge voltage value; and
    a processor that calculates an integrated amount of expansion damage that is damage received by the battery due to expansion of the battery, the processor decreasing the full charge voltage value when an expansion damage rate that is an increase rate of the integrated amount in a predetermined period is equal to or greater than a threshold value, while the processor increasing the full charge voltage value when the expansion damage rate is less than the threshold value.

2.  The charging control device according to claim 1, further including

    a temperature sensor that detects a temperature of the battery, wherein
    the processor calculates the integrated amount on the basis of a predetermined upper limit value of the full charge voltage value, the full charge voltage value at a moment, and the temperature.

3.  The charging control device according to claim 1, wherein

    the threshold value includes a first threshold value and a second threshold value that is a value smaller than the first threshold value, and
    the processor decreases the full charge voltage value when the expansion damage rate is equal to or greater than the first threshold value, while the processor increases the full charge voltage value when the expansion damage rate is less than the second threshold value.

4.  The charging control device according to claim 1, wherein
    the processor decreases the full charge voltage value as a number of charging cycles of the battery increases, while the processor decreases or increases the full charge voltage value on the basis of the expansion damage rate with the full charge voltage value set according to the number of charging cycles as an upper limit value.

5.  The charging control device according to claim 1, wherein
    the processor calculates the expansion damage rate by using the predetermined period shorter as the full charge voltage value is larger.

6.  A mobile terminal device including the charging control device according to claim 1.

7.  A charging control method for a battery that is charged until an output voltage value reaches a full charge voltage value, the method including:

calculating an integrated amount of expansion damage that is damage received by the battery due to expansion of the battery; and

decreasing the full charge voltage value when an expansion damage rate that is an increase rate of the integrated amount in a predetermined period is equal to or greater than a threshold value, while increasing the full charge voltage value when the expansion damage rate is less than the threshold value.

8.  A program for causing a processor to execute charging control for a battery that is charged until an output voltage value reaches a full charge voltage value,

the program for causing the processor to execute processing of:

calculating an integrated amount of expansion damage that is damage received by the battery due to expansion of the battery; and

decreasing the full charge voltage value when an expansion damage rate that is an increase rate of the integrated amount in a predetermined period is equal to or greater than a threshold value, while increasing the full charge voltage value when the expansion damage rate is less than the threshold value.

# FIG.1

1

# FIG.2

# FIG.3

# FIG.4

## INTERNATIONAL SEARCH REPORT

| International application No. |
| --- |
| PCT/JP2020/033476 |

**A. CLASSIFICATION OF SUBJECT MATTER**
Int. Cl. H01M10/44(2006.01)i, H01M10/48(2006.01)i
FI: H01M10/48 P, H01M10/44 P

According to International Patent Classification (IPC) or to both national classification and IPC

**B. FIELDS SEARCHED**

Minimum documentation searched (classification system followed by classification symbols)
Int. Cl. H01M10/44, H01M10/48

Documentation searched other than minimum documentation to the extent that such documents are included in the fields searched
Published examined utility model applications of Japan     1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2011-061391 A (SHARP CORP.) 24 March 2011, paragraphs [0021]-[0061], fig. 1-4 | 1-8 |
| A | JP 2018-085781 A (TOYOTA INDUSTRIES CORP.) 31 May 2018, paragraphs [0020]-[0039], fig. 1-5 | 1-8 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 30.09.2020 | 13.10.2020 |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**
Information on patent family members

| International application No. |
| --- |
| PCT/JP2020/033476 |

| Patent Documents referred to in the Report | Publication Date | Patent Family | Publication Date |
| --- | --- | --- | --- |
| JP 2011-061391 A | 24.03.2011 | (Family: none) | |
| JP 2018-085781 A | 31.05.2018 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020068607 A